# EUROPEAN PATENT APPLICATION

(11) **EP 4 531 109 A1**
(43) Date of publication of application: **02.04.2025**
(21) Application number: 23201063.7
(22) Date of filing: 29.09.2023
(51) Int. Cl.: H01L 29/06, H01L 29/08, H01L 29/78, H01L 21/336

(54) **SEMICONDUCTOR DEVICE AND METHOD OF MANUFACTURING SEMICONDUCTOR DEVICE**

(71) Applicant: Nexperia B.V., 6534 AB Nijmegen (NL)
(72) Inventor: Teichrib, Jakob, 22529 Hamburg (DE); Stein, Falk-Ulrich, 22529 Hamburg (DE)
(74) Representative: Pjanovic, Ilija

(57) **Abstract**

The present disclosure relates to a semiconductor device and a method of manufacturing semiconductor device. The present disclosure relates particularly to MOSFET transistors. A semiconductor device according to the disclosure comprising: a first-conductivity-type substrate, a first-conductivity-type epitaxy layer comprising a JFET region and a second-conductivity-type shield region, two well regions comprising two source regions, gate oxide comprising a gate, a drain adjacent to the first-conductivity-type substrate, wherein the first-conductivity-type substrate is adjacent to the first-conductivity-type epitaxy layer, wherein the two well regions are adjacent to the first-conductivity-type epitaxy layer, wherein the JFET region is located between the two well regions, wherein the source contact region is the outermost layer and is adjacent to the two source regions, wherein the gate oxide is adjacent to the two well regions, the two source regions, and the JFET region.

## Description

### TECHNICAL FIELD

The present disclosure relates to a semiconductor device and a method of manufacturing semiconductor device. The present disclosure relates particularly to MOSFET transistors.

### BACKGROUND OF THE DISCLOSURE

Transistors with a gate oxide, such as the metal-oxide-semiconductor field-effect transistor (MOSFET) can face the issue of elevated electric fields at the oxide. This is especially true for power MOSFETs operated at high voltages, e.g. those made from silicon carbide. Under normal operating conditions a high potential difference is created between the gate and drain terminal. If the electric field at the gate interface is too large, a deterioration or destruction of the oxide layer can occur, especially if imperfections in the oxide or interface material are present. The MOSFET might be rendered useless in such a case, as it would not be able to perform any switching actions.

Document US9685550B2 discloses an apparatus can include a silicon carbide (SiC) device can include a gate dielectric, a first doped region having a first conductivity type, a body region of the first conductivity type, and a second doped region having a second conductivity type. The second doped region has a first portion disposed between the first doped region and the body region, and the second doped region has a second portion disposed between the first doped region and the gate dielectric.

Document US9530844B2 discloses a transistor device having reduced electrical field at the gate oxide interface is disclosed. In one embodiment, the transistor device comprises a gate, a source, and a drain, wherein the gate is at least partially in contact with a gate oxide. The transistor device has a P+ region within a JFET region of the transistor device in order to reduce an electrical field on the gate oxide.

Document JP6338134B2 discloses a vertical MOSFET and a manufacturing method thereof, and more particularly, to a structure of a vertical MOSFET that realizes both improvement of device breakdown voltage and reduction of on-resistance and a manufacturing method thereof. To achieve both of improvement in element withstanding voltage and reduction in on-resistance at the same time by generating a depletion layer at a joint surface between a drift layer which is an n-type withstanding voltage region and a high-concentration p-type layer even when an impurity concentration of the drift layer of the silicon carbide vertical MOSFET is increased.

Document US9093493B2 discloses a wide bandgap insulated gate semiconductor device includes a semiconductor substrate made of semiconductor having a bandgap wider than silicon; n⁻ drift layer over the semiconductor substrate; p-channel regions selectively disposed over the drift layer; n⁺ semiconductor regions selectively disposed in respective surfaces in the channel regions; a plurality of p⁺ base regions in contact with bottoms of the respective channel regions; a protruding drift layer portion that is n-type region interposed between the p-channel regions and the p⁺ base regions thereunder; a gate electrode formed, through a gate insulating film, on the protruding drift layer portion and on respective surfaces of the p-channel regions; a source electrode in contact with the n⁺ semiconductor regions in the channel regions; and a p⁺ floating region inside the protruding drift layer portion, having side faces respectively facing side faces of the second conductivity type base regions, wherein respective gaps between the p⁺ base regions and the p⁺ floating region defined by the respective side faces have a wide portion and a narrow portion.

In prior art a shielding region has been implanted between the wells of the transistor, also known as JFET region, either at the gate insulator interface or cantered or at a lower end of the region between the wells, but always on the same vertical space than that of the wells. In this invention the shielding region is located below the wells in a vertical direction, yet still between the wells from a horizontal perspective. In other words, the shielding region is located below the JFET region.

Accordingly, it is a goal of the present disclosure to provide an improved MOSFET transistor where the electric field close to the gate oxide interface is reduced by creating a shielding region below the JFET region that is located between the well regions. To fully harness the shielding potential, the shielding region should be connected to the source terminal in the depth of the semiconductor. The oxides are susceptible to the electrical field, and the reduction/avoidance of electrical field in the oxides does not affect JFETS.

### SUMMARY OF THE DISCLOSURE

According to a first example of the disclosure a semiconductor device is disclosed. The semiconductor device comprising: a first-conductivity-type substrate, a first-conductivity-type epitaxy layer comprising a JFET region and a second-conductivity-type shield region, two well regions comprising two source regions, gate oxide comprising a gate, a drain adjacent to the first-conductivity-type substrate. The first-conductivity-type substrate is adjacent to the first-conductivity-type epitaxy layer. The two well regions are adjacent to the first-conductivity-type epitaxy layer. The JFET region is located between the two well regions. The source contact region is adjacent to the two source regions. The gate oxide is adjacent to the two well regions, the two source regions, and the JFET region.

Preferably the second-conductivity-type shield region is located at a depth deeper than a lower edge of the well regions or at the same depth as the lower edge of the well regions, and at least part of the second-conductivity-type shield region overlaps with the JFET region.

Preferably a distance of the second-conductivity-type shield region to each of the two well regions is the same.

Preferably the first-conductivity-type epitaxy layer comprising a second first-conductivity-type layer such that at least JFET region, and preferably the second-conductivity-type shield region, is located within the second first-conductivity-type layer. The second first-conductivity-type layer has a higher dopant concentration than the first-conductivity-type epitaxy layer.

Preferably the second-conductivity-type shield region comprises dopants of both types.

Preferably the second-conductivity-type shield region is doped to the same doping concentration as the well region.

Preferably the second-conductivity-type shield region is doped such that it has higher doping concentration than the well region.

Preferably the second-conductivity-type shield region edges are rounded.

Preferably at least one end of the second-conductivity-type shield region is connected to the well region. Even more preferably both ends of the second-conductivity-type shield region are connected to the well region.

According to a second example of the disclosure a method of manufacturing a semiconductor device is disclosed. The method comprising steps of: a) depositing of a first-conductivity-type epitaxy layer on top first-conductivity-type substrate, b) depositing of a scatter oxide layer on top of the first-conductivity-type epitaxy layer, c) creating a first mask on top of the scatter oxide layer, d) creating a second-conductivity-type shield region in the first-conductivity-type epitaxy layer by first implantation of a second-conductivity-type dopant through the first mask, e) removing the first mask, f) creating a second mask above the second-conductivity-type shield region, g) creating well regions by second implantation of second-conductivity-type dopant through the second mask, h) creating the third mask which is wider than the second mask, i) creating source regions by second implantation of first-conductivity-type dopant through the third mask.
Preferably, after step b), a second first-conductivity-type layer is created by a first implantation of first-conductivity-type dopant on the first-conductivity-type epitaxy layer.
Preferably, during step h), the third mask is created by adding spacers to the second mask.
Preferably, after step g), a fourth mask is placed over the well regions and the third implantation of second-conductivity-type dopant such that the connection between the well regions and the second-conductivity-type shield region is created.

### BRIEF DESCRIPTION OF THE DRAWINGS

The disclosure will now be discussed with reference to the drawings, which show in:
Figure 1 shows a cross-section of a semiconductor device prior to applying first masks,
Figure 2 shows a cross-section of the semiconductor device with the first masks applied,
Figure 3 shows a cross-section of the semiconductor device during a creation of a shield region,
Figure 4 shows a cross-section of the semiconductor device with a second mask applied,
Figure 5 shows a cross-section of the semiconductor device during a creation of well regions,
Figure 6 shows a top view of the semiconductor device,
Figure 7a, 7b, 7c show a cross-section of the semiconductor device - the A cross-section as shown in figure 6 in different variants,
Figure 8a, 8b, 8c show a cross-section of the semiconductor device - the B cross-section as shown in figure 6 in different variants, ,
Figure 8d shows a manufacturing process for a semiconductor device as shown in fig. 8b and 8c,
Figure 9 shows a cross-section of the semiconductor device with a third mask applied
Figure 10 shows a cross-section of the semiconductor device during a creation of source regions,

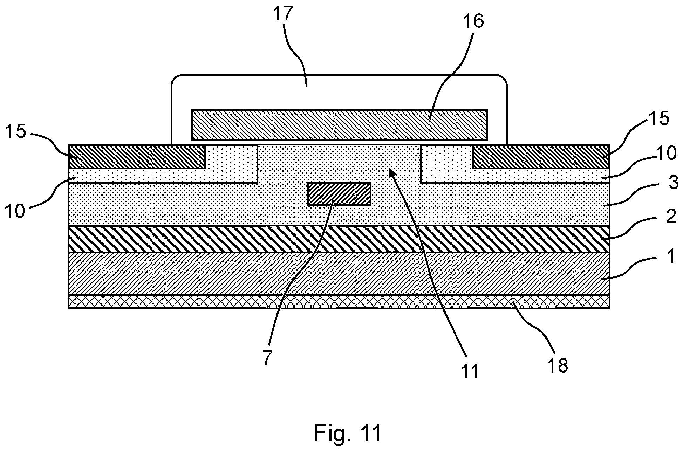

Figure 11 shows a cross-section of a finished semiconductor device.

### DETAILED DESCRIPTION OF THE DISCLOSURE

For a proper understanding of the disclosure, in the detailed description below corresponding elements or parts of the disclosure will be denoted with identical reference numerals in the drawings.

A method of manufacturing a semiconductor device according to the invention, as briefly described, will comprise a following steps, which will be described in a greater detail hereinafter. The method comprising steps of :
a) depositing of a first-conductivity-type epitaxy layer 2 on top of a first-conductivity-type substrate 1,
b) depositing of a scatter oxide layer 4 on top of the first-conductivity-type epitaxy layer 2,
c) creating a first mask 6 on top of the scatter oxide layer 4,
d) creating a second-conductivity-type shield region 7 in the first-conductivity-type epitaxy layer 2 by first implantation 14 of a first-conductivity-type dopant through the first mask 6,
e) removing the first mask 6,
f) creating a second mask 8 above the second-conductivity-type shield region 7,
g) creating well regions 10 by second implantation 9 of second-conductivity-type dopant through the second mask 8,
h) creating the third mask 12 which is wider than the second mask 8,
i) creating source regions 15 by second implantation 13 of first-conductivity-type dopant through the third mask 12.

First steps of manufacturing of a semiconductor device according to the invention are not shown in figures since those are the same steps as in the prior art methods. A first-conductivity-type substrate 1 is used as a substrate, on which a first-conductivity-type epitaxy layer 2 is deposited - this layer serves as a drift layer for the semiconductor device. Next, on top of the first-conductivity-type epitaxy layer 2, a scatter oxide layer 4 is deposited to improve the subsequent implant processes. It should be noted that the scatter oxide layer 4 is only needed for the manufacturing process. A final structure will not have the scatter oxide layer 4.

It should be noted that throughout the whole description terms "first-conductivity-type" and "second-conductivity-type" will be used. Since the semiconductor device will have regions made as a semiconductor (typically silicon or germanium) doped with impurities for the purpose of modulating semiconductor's properties. Since mentioned impurities either provide electrons (impurities are donors) or holes (impurities are acceptors) those regions are often referred to as n-type or p-type regions. In this description it should be understood that in the case that the first-conductivity-type may mean p-type, the second-conductivity-type will be n-type. The invention will also work the other way around. The Applicant wishes not to focus on an exact types of regions but rather on a general idea behind this invention.

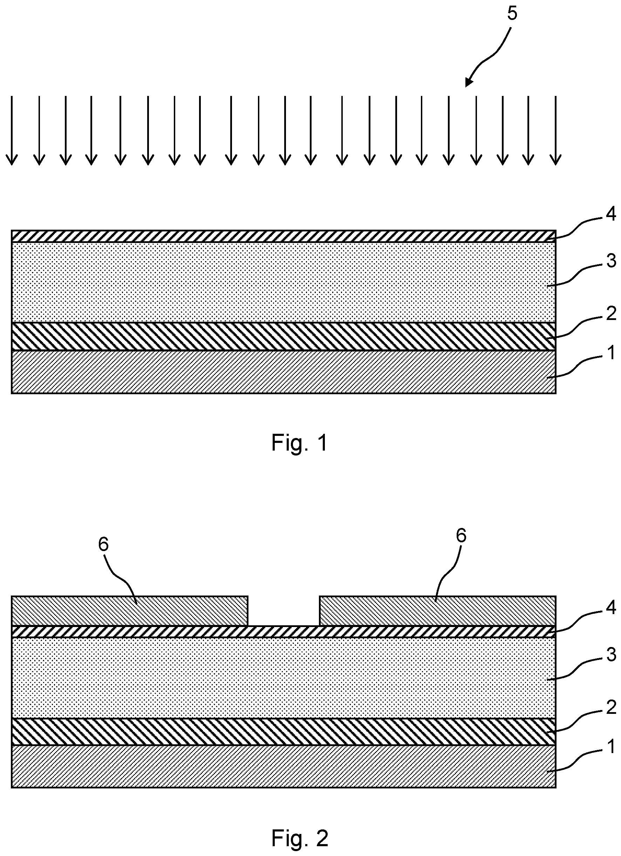

In fig. 1 an additional step of a surface-wide first implantation 5 of first-conductivity type is shown, which is forming a second first-conductivity-type layer 3 within the first-conductivity-type epitaxy layer 2, which would alter the JFET region 11. The first implantation 5 can be shallower or deeper than the subsequent second implantation 9 of second-conductivity-type dopant, which will form well regions 10. In the following illustrations, a deeper variant is shown.

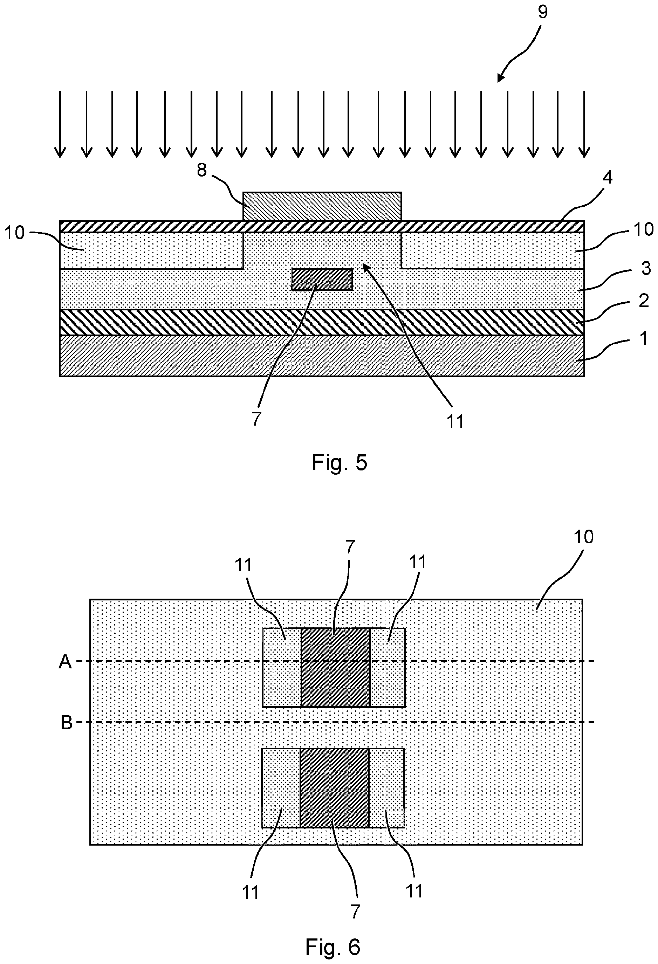

In fig. 2 a final effect of a next step is shown which is a formation of first masks 6. It should be noted that there is a gap between the first masks 6. It should be also noted that in a reality there might be a single first mask 6 as shown in fig. 6, throughout the whole description, while referring to other figures, a plural form will be used.

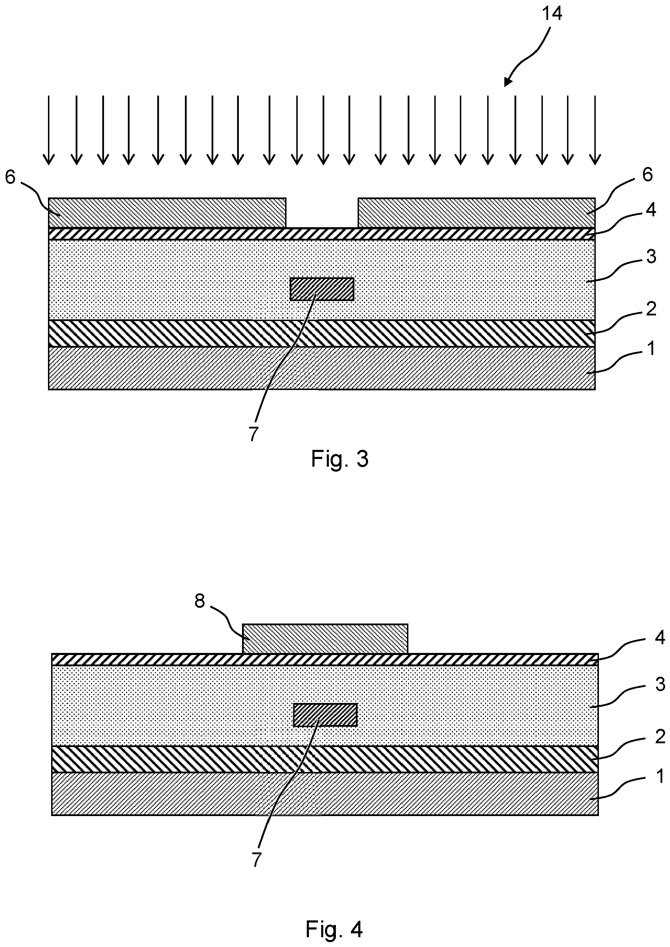

In fig. 3 a first implantation 14 of second-conductivity-type dopant is shown. Through the first masks 6 an implant of a second-conductivity-type shield region 7 is performed, effectively creating a deep region of second conductivity type. For that, the doping concentration created by the first implantation 14 of second-conductivity-type dopant has to overcome that of the background doping of the first-conductivity-type epitaxy layer 2. If the surface-wide first implantation 5 has been done the doping concentration of by the first implantation 14 of second-conductivity-type dopant has to overcome that of the surface-wide first implantation 5.

A purpose of the second-conductivity-type shield region 7 is that it will reduce an electrical field at a gate insulator interface at the completed transistor. A deeply implanted region below the gate, here the second-conductivity-type shield region 7, shields the gate from an elevated electric field that could potentially cause its deterioration or destruction.

In fig. 4 a final effect of a next step is shown which is a formation of a second mask 8. The second mask 8 is created after the removal of the first mask 6 on the scatter oxide layer 4. The second mask 8 is located above the previously implanted second-conductivity-type shield region 7

In fig. 5 a second implantation 9 of second-conductivity-type dopant is shown. After this step the well regions 10 will be formed. The second-conductivity type well regions 10 are implanted in such a way that they are not as deep as the second-conductivity-type shield region 7. The region between the well regions 10 is called the JFET region 11. Anything lower than the bottom of the second-conductivity type well region 10 is no longer a JFET region 11.

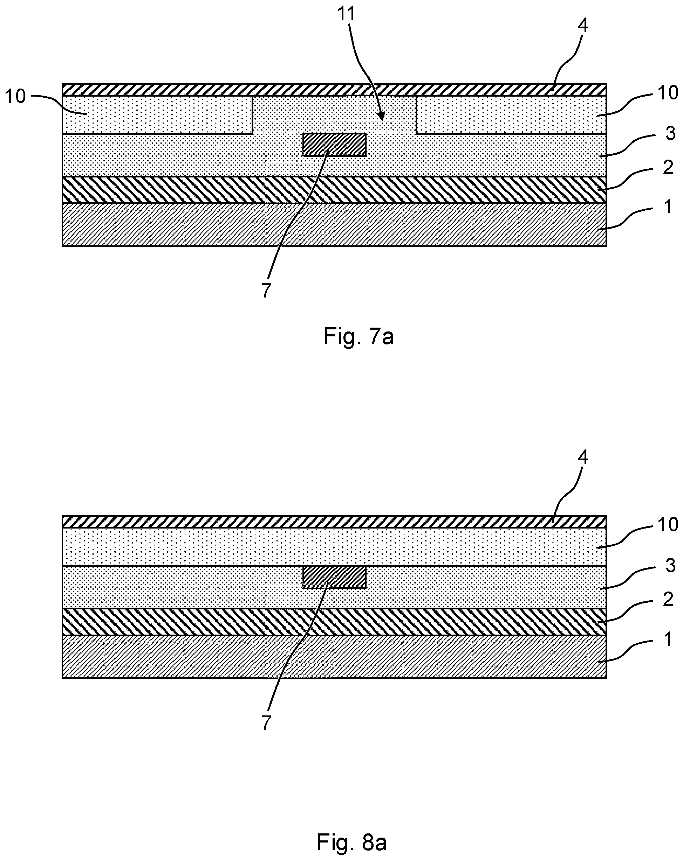

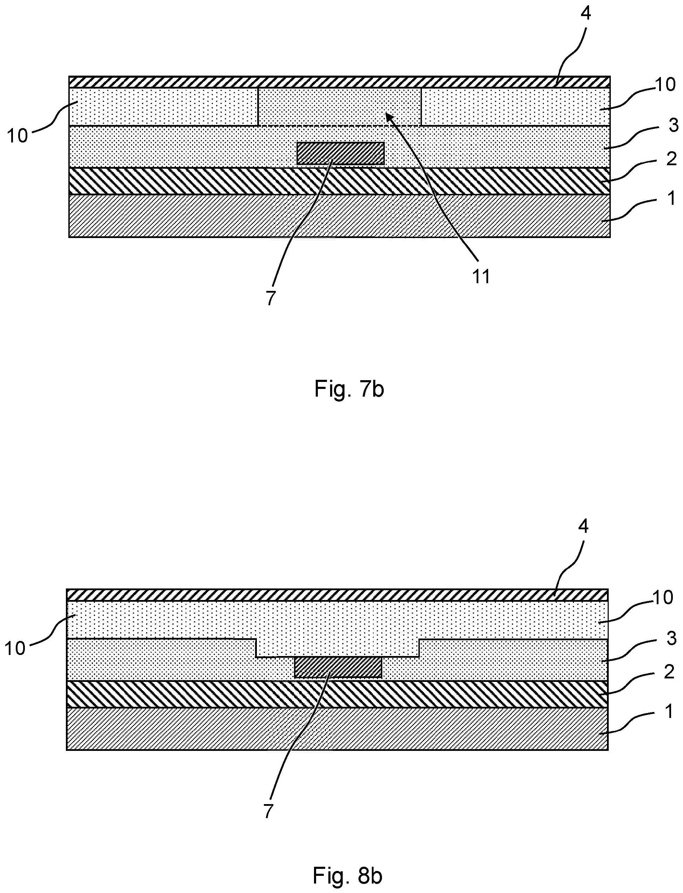

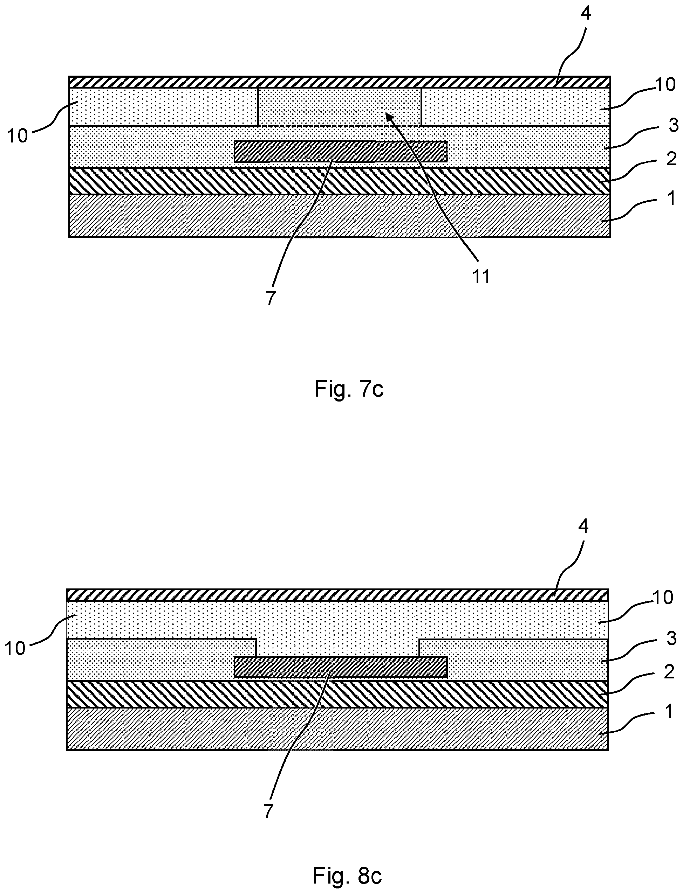

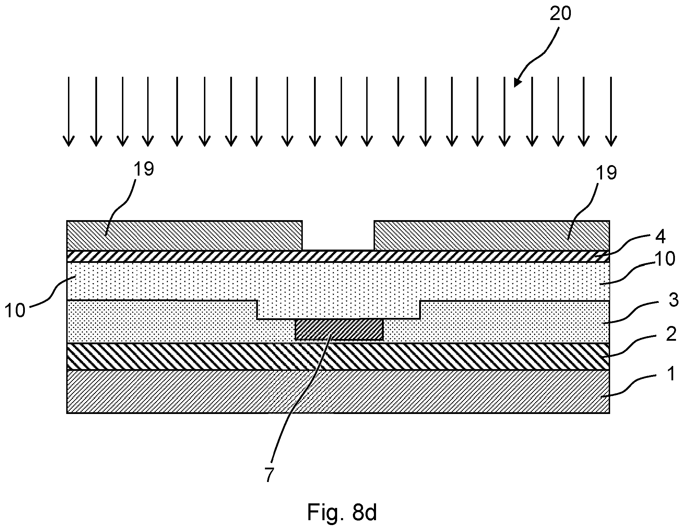

In fig. 6 a top view of the semiconductor device is shown after the second implantation 9 of second-conductivity-type dopant. Two cross-sections A and B are shown in fig. 7a, 7b, 7c and 8a, 7b, 7c respectively. To fully use the shielding potential of the second-conductivity-type shield region 7, it should not be left floating but should be electrically connected to the source potential. For this, the second-conductivity-type shield region 7 could be connected to the well region 10 in the depth of the semiconductor. One end or both ends of second-conductivity-type shield region 7 may be connected to the well region 10. It should be noted that different variants of the shield region 7 may be used - in fig. 7a and 7b the shield region 7 narrower than the JFET region 11 is present, wherein the shield region 7 top edge is on a similar depth as a lower edge of the well region 10. In fig. 7a and 7b the shield region 7 is located deeper than in fig. 7a and 7b - it should be noted that the well region 10 must go deeper than previously so that the well region 10 is able to connect to the shield region 7. In fig 7c and 8c the shield region 7 is as deep as in fig. 7b and 7c however it is now longer than the JFET region 11. In fig. 8d a manufacturing of the deeper part of the well region 10, as presented in fig. 8b and 8c, is shown. Additional masks, namely fourth masks 19, are placed over the well regions 10. In a desired place for a contact, in this example in the B cross-sections, a third implantation 20 of second-conductivity-type dopant is performed such that both well regions 10 and the shield region 7 are connected. After this step the fourth masks 19 are removed.

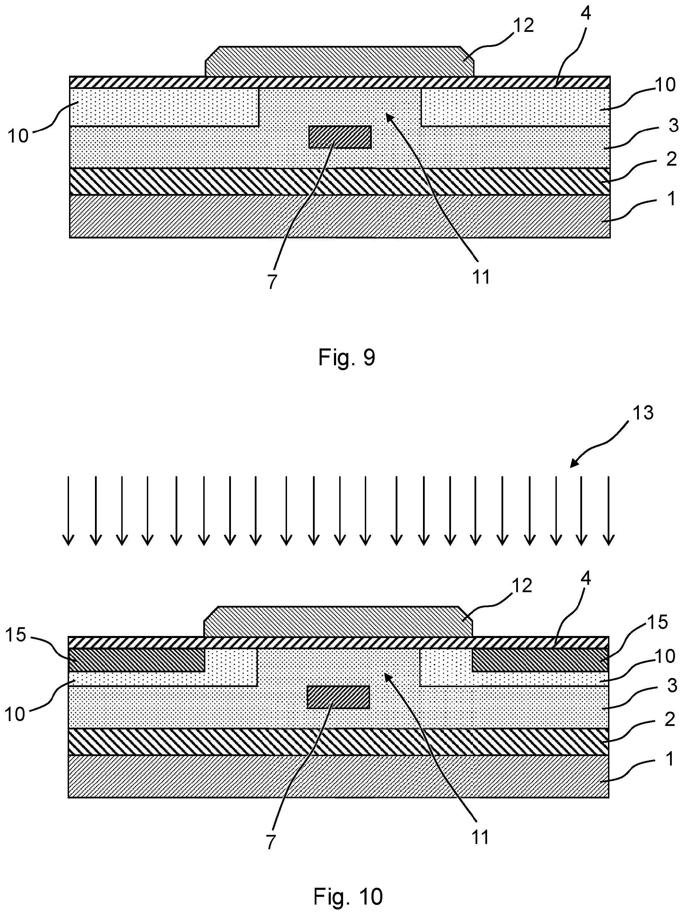

In fig. 9 a final effect of a next step is shown which is a formation of a third mask 12. It should be noted that preferably the third mask 12 is created by adding more spacers to the second mask 8, effectively resulting in a mask wider than the second mask 8.

In fig. 10 a second implantation 13 of first-conductivity-type dopant is shown. This step results in a creation of the source regions 15.

Subsequent manufacturing of gate oxides, terminal contacts at gate/drain/source, interlayer dielectrics, metallizations and passivations are done to complete the device, as typically is done during a standard manufacturing process. These steps are not a key feature of the device and are therefore not described in a greater detail since the person skilled in the art will know how to finish a product as described in this application.

During the abovementioned process a half-finished semiconductor device is manufactured which comprises a first-conductivity-type substrate 1, a first-conductivity-type epitaxy layer 2 comprising a JFET region 11 and a second-conductivity-type shield region 7, two well regions 10 comprising two source regions 15, and a scatter oxide layer 4. The first-conductivity-type substrate 1 is adjacent to the first-conductivity-type epitaxy layer 2. The two well regions 10 are adjacent to the first-conductivity-type epitaxy layer 2. The JFET region 11 is adjacent to the two well regions 10. The scatter oxide layer 4 is the outermost layer and is adjacent to the two source regions 15, the two well regions 10 and the JFET region 11.

The semiconductor device, as a finished product, comprising a first-conductivity-type substrate 1, a first-conductivity-type epitaxy layer 2 comprising a JFET region 11 and a second-conductivity-type shield region 7, two well regions 10 comprising two source regions 15, gate oxide 17 comprising a gate 16, a drain 18 adjacent to the first-conductivity-type substrate 1. The first-conductivity-type substrate 1 is adjacent to the first-conductivity-type epitaxy layer 2.The two well regions 10 are adjacent to the first-conductivity-type epitaxy layer 2, The JFET region 11 is located between the two well regions 10. The source contact region is adjacent to the two source regions 15. The gate oxide 17 is adjacent to the two well regions 10, the two source regions 15, and the JFET region 11.

In another embodiment the second-conductivity-type shield region 7 is narrower than the JFET region 11.

The second-conductivity-type shield region 7 is located at a depth deeper than a lower edge of the well regions 10 or at the same depth as the lower edge of the well regions (10), and at least part of the second-conductivity-type shield region 7 overlaps with the JFET region 11.

In yet another embodiment distance of the second-conductivity-type shield region 7 to each of the two well regions 10 is the same.

As mentioned herein before the first-conductivity-type epitaxy layer 2 may comprise a second first-conductivity-type layer 3 such that at least JFET region 11, and preferably the second-conductivity-type shield region 7, is located within the second first-conductivity-type layer 3, wherein the second first-conductivity-type layer 3 has a higher dopant concentration than the first-conductivity-type epitaxy layer 2.

The semiconductor device manufactured as described hereinbefore will have the second-conductivity-type shield region 7 which comprising dopants of both types. However it should be noted that other manufacturing steps may be taken and such structure with both dopant types may not be present. Preferably the second-conductivity-type shield region 7 is doped to at least the same doping concentration as the well region 10, even more preferably the second-conductivity-type shield region 7 is doped such that it has higher doping concentration than the well region 10.

In another embodiment the second-conductivity-type shield region 7 edges are rounded - sharp edges will result in high electric fields which should be avoided.

If the second-conductivity-type shield region 7 is too small, there may not be a shielding effect (as the shielding reach is smaller); and if it is too large this may restrict current flow which may be beneficial in some kinds of protection elements such as an electric fuse.

### LIST OF REFERENCE NUMERALS USED

- 1: first-conductivity-type substrate
- 2: first-conductivity-type epitaxy layer
- 3: second first-conductivity-type layer
- 4: scatter oxide layer
- 5: first implantation of first-conductivity-type dopant
- 6: first mask
- 7: second-conductivity-type shield region
- 8: second mask
- 9: second implantation of second-conductivity-type dopant
- 10: well region
- 11: JFET region
- 12: third mask
- 13: second implantation of first-conductivity-type dopant
- 14: first implantation of second-conductivity-type dopant
- 15: source region
- 16: gate
- 17: gate oxide
- 18: drain
- 19: fourth mask
- 20: third implantation of second-conductivity-type dopant

## Claims

1. A semiconductor device comprising:
a first-conductivity-type substrate (1),
a first-conductivity-type epitaxy layer (2) comprising a JFET region (11) and a second-conductivity-type shield region (7),
two well regions (10) comprising two source regions (15),
gate oxide (17) comprising a gate (16),
a drain (18) adjacent to the first-conductivity-type substrate (1),
wherein the first-conductivity-type substrate (1) is adjacent to the first-conductivity-type epitaxy layer (2),
wherein the two well regions (10) are adjacent to the first-conductivity-type epitaxy layer (2),
wherein the JFET region (11) is located between the two well regions (10),
wherein the source contact region is adjacent to the two source regions (15),
wherein the gate oxide (17) is adjacent to the two well regions (10), the two source regions (15), and the JFET region (11).

2. The semiconductor device according to claim 1, wherein the second-conductivity-type shield region (7) is located at a depth deeper than a lower edge of the well regions (10) or at the same depth as the lower edge of the well regions (10), and at least part of the second-conductivity-type shield region (7) overlaps with the JFET region (11).

3. The semiconductor device according to claim 1 or 2, wherein a distance of the second-conductivity-type shield region (7) to each of the two well regions (10) is the same.

4. The semiconductor device according to anyone of the previous claims, wherein the first-conductivity-type epitaxy layer (2) comprising a second first-conductivity-type layer (3) such that at least JFET region (11), and preferably the second-conductivity-type shield region (7), is located within the second first-conductivity-type layer (3), wherein the second first-conductivity-type layer (3) has a higher dopant concentration than the first-conductivity-type epitaxy layer (2).

5. The semiconductor device according to anyone of the previous claims, wherein the second-conductivity-type shield region (7) comprises dopants of both types.

6. The semiconductor device according to anyone of the previous claims, wherein the second-conductivity-type shield region (7) is doped to the same doping concentration as the well region (10).

7. The semiconductor device according to anyone of the claims 1-6, wherein the second-conductivity-type shield region (7) is doped such that it has higher doping concentration than the well region (10).

8. The semiconductor device according to anyone of the previous claims, wherein the second-conductivity-type shield region (7) edges are rounded.

9. The semiconductor device according to anyone of the previous claims, wherein at least one end of the second-conductivity-type shield region (7) is connected to the well region (10), preferably both ends of the second-conductivity-type shield region (7) are connected to the well region (10).

10. A method of manufacturing a semiconductor device according to anyone of the claims 1-8, comprising steps of:
a) depositing of a first-conductivity-type epitaxy layer (2) on top first-conductivity-type substrate (1),
b) depositing of a scatter oxide layer (4) on top of the first-conductivity-type epitaxy layer (2),
c) creating a first mask (6) on top of the scatter oxide layer (4),
d) creating a second-conductivity-type shield region (7) in the first-conductivity-type epitaxy layer (2) by first implantation (5) of a second-conductivity-type dopant through the first mask (6),
e) removing the first mask (6),
f) creating a second mask (8) above the second-conductivity-type shield region (7),
g) creating well regions (10) by second implantation (9) of second-conductivity-type dopant through the second mask (8),
h) creating the third mask (12) which is wider than the second mask (8),
i) creating source regions (15) by second implantation (13) of first-conductivity-type dopant through the third mask (15).

11. The method according to claim 10, wherein, after step b), a second first-conductivity-type layer (3) is created by a first implantation (5) of first-conductivity-type dopant on the first-conductivity-type epitaxy layer (2).

12. The method according to claim 10 or 11, wherein, during step h), the third mask (12) is created by adding spacers to the second mask (8).

13. The method according to anyone of claims 10-12, wherein, after step g), a fourth mask (19) is placed over the well regions (10) and the third implantation (20) of second-conductivity-type dopant such that the connection between the well regions (10) and the second-conductivity-type shield region (7) is created.
